# EUROPEAN PATENT SPECIFICATION

(11) **EP 4 460 898 B1**
(45) Date of publication and mention of the grant of the patent: **14.10.2026**
(21) Application number: 23718161.5
(22) Date of filing: 17.03.2023
(51) Int. Cl.: H03K 5/156, G11C 7/22

(54) **DUTY CYCLE CORRECTION CIRCUIT AND DUTY CYCLE CORRECTING METHOD**
ARBEITSZYKLUSKORREKTURSCHALTUNG UND ARBEITSZYKLUSKORREKTURVERFAHREN
CIRCUIT DE CORRECTION DE CYCLE DE SERVICE ET PROCÉDÉ DE CORRECTION DE CYCLE DE SERVICE

(30) Priority: 30.12.2022 US 202263436449 P
(43) Date of publication of application: 13.11.2024
(73) Proprietor: Yangtze Memory Technologies Co., Ltd., Wuhan, Hubei 430000 (CN)
(72) Inventor: LEE, Byoung Woon, Wuhan, Hubei 430000 (CN); LUO, Jian, Wuhan, Hubei 430000 (CN); SONG, Hang, Wuhan, Hubei 430000 (CN)
(74) Representative: Lippert Stachow Patentanwälte Rechtsanwälte
(86) International application number: PCT/CN2023/082098
(87) International publication number: WO 2024/138890

(56) References cited:
- US-A1- 2021 152 167
- US-B1- 10 218 343
- TRUESDELL DANIEL S ET AL: "A 0.5-V 560-kHz 18.8-fJ/Cycle On-Chip Oscillator With 96.1-ppm/°C Steady-State Stability Using a Duty-Cycled Digital Frequency-Locked Loop", IEEE JOURNAL OF SOLID-STATE CIRCUITS, IEEE, USA, vol. 56, no. 4, 14 January 2021 (2021-01-14), pages 1241 - 1253, XP011846231, ISSN: 0018-9200, [retrieved on 20210325], DOI: 10.1109/JSSC.2020.3048664

## Description

### CROSS-REFERENCE TO RELATED APPLICATIONS

This application claims the benefit of priority to U.S. Provisional Application No. 63/436,449, filed on December 30, 2022.

### TECHNICAL FIELD

The present disclosure generally relates to the field of signal processing technology, and more particularly, to a duty cycle correction circuit and a duty cycle correcting method.

### BACKGROUND

High-speed lock signals are widely used for adjusting operational timing in various systems and circuits. While the high-speed clock signal is used inside of the systems and circuits, the high-speed clock signal is often distorted. Such distortion of the high-speed clock signal can cause unstable operations or even abnormal operations of the system. It is important to correct the distortion to secure a reliable operation. A duty cycle correction (DCC) circuit is generally required to correct the high-speed clock signal to a normal value.

The US 10 218 343 B1 describes a circuit including a control circuitry configured to determine a duty cycle error for a sample clock signal. The non-patent literature article in IEEE JOURNAL OF SOLID-STATE CIRCUITS with the DOI: 10.1109/JSSC.2020.3048664 of TRUESDELL DANIEL S ET AL describes an on-chip oscillator for energy-efficient Internet-of-Things applications based on a duty-cycled digital frequency-locked loop that reduces energy by disabling energy-hungry components and only periodically reactivating them to keep the output frequency stabilized during temperature drifts.

### SUMMARY

The invention is defined as set out in the independent claims 1 and 3. Further embodiments are described in the dependent claims.

An aspect of the invention provides a method for duty cycle correction, comprising: performing a first loop of duty tuning operations to a clock signal by using a first method; in response to determining that a first loop count of the first loop, wherein the first loop count is the number of iterations of the first loop of duty tuning operations, reaches a first threshold value, or determining that a duty cross occurs, performing a second loop of duty tuning operations to the clock signal by using a second method different from the first method; in response to determining that a second loop count of the second loop, wherein the second loop count is the number of iterations of the second loop of duty tuning operations, reaches a second threshold value, executing a duty check to the clock signal; and in response to determining that the clock signal has a duty cycle within a target range,passing the duty cycle correction, wherein the first method is a linear approximation method, and the second method is a binary weighted approximation method; and wherein the method further comprises: before performing the first loop of duty tuning operations, converting the clock signal to a pair of differentiated clock signals, preferably further comprising: converting the pair of differentiated clock signals to a pair of voltages, respectively; and comparing the pair of voltages to output a comparison signal to indicate whether the duty cross occurs.

Another aspect of the present invention provides a circuit for duty cycle correction, comprising: at least one low pass filter configured to convert a clock signal to a voltage; a voltage comparator configured to compare the voltage with a reference voltage to output a comparison signal; a controller configured to select, based on the comparing voltage, a duty cycle correction method from a first method and a second method different from the first method; and a duty regulator configured to perform a duty tuning operation to adjust a duty of the clock signal using the selected duty cycle correction method.

According to the invention, the first method is a linear approximation method; and the second method is a binary weighted approximation method.

In some implementations, the circuit can further comprise: a single-to-differential converter configured to convert the clock signal to a pair of differentiated clock signals.

In some implementations, the at least one low pass filter comprises a pair of low pass filters configured to convert the pair of differentiated clock signals to a pair of voltages, respectively; and the voltage comparator is configured to compare the pair of voltages to generate the comparison signal indicating whether a duty cross occurs.

In some implementations, the controller is further configured to: select the linear approximation method in response to the comparison signal indicating that the duty cross does not occur; and select the binary weighted approximation method in response to the comparison signal indicating that the duty cross occurs.

In some implementations, the controller is further configured to: count a first loop count of a first subset of loops of duty tuning operations using the linear approximation method; and in response to determining that the first loop count reaches a first threshold value, select the binary weighted approximation method.

In some implementations, the controller is further configured to: in response to determining that the first loop count does not reach the first threshold value and the comparison signal indicating that the duty cross does not occur, select the linear approximation method.

In some implementations, the controller is further configured to: count a second loop count of a second subset of loops of duty tuning operations using the binary weighted approximation method; and in response to determining that the second loop count reaches a second threshold value, perform a duty check operation to determine whether the clock signal has a duty within a target range.

In some implementations, the controller is further configured to: in response to determining that the duty of the clock signal is within the target range, generate a pass signal indicating that the duty cycle correction is successful; and in response to determining that the duty of the clock signal is without the target range, generate a fail signal indicating that the duty cycle correction is unsuccessful.

Another aspect of the present invention provides a memory system, comprising: a memory device; and a peripheral circuit configured to control the memory device, the peripheral circuit comprising a duty cycle correction circuit. The duty cycle correction circuit comprises: at least one low pass filter configured to convert a clock signal to a voltage, a voltage comparator configured to compare the voltage with a reference voltage to output a comparison signal, a controller configured to select, based on the comparing voltage, a duty cycle correction method from a first method and a second method different from the first method, and a duty regulator configured to perform a duty tuning operation to adjust a duty of the clock signal using the selected duty cycle correction method.

According to the invention, the first method is a linear approximation method; and the second method is a binary weighted approximation method.

In some implementations, the duty cycle correction circuit further comprises: a single-to-differential converter configured to convert the clock signal to a pair of differentiated clock signals.

In some implementations, the at least one filter comprises a pair of low pass filters configured to convert the pair of differentiated clock signals to a pair of voltages, respectively; and the voltage comparator is configured to compare the pair of voltages to generate the comparison signal indicating whether a duty cross occurs.

In some implementations, the controller is further configured to: count a first loop count of a first subset of loops of duty tuning operations using the linear approximation method; in response to determining that the first loop count reaches a first threshold value or the comparison signal indicating that the duty cross occurs, select the binary weighted approximation method; and in response to determining that the first loop count does not reaches the first threshold value and the comparison signal indicating that the duty cross does not occur, select the linear approximation method.

In some implementations, the controller is further configured to: count a second loop count of a second subset of loops of duty tuning operations using the binary weighted approximation method; and in response to determining that the second loop count reaches a second threshold value, perform a duty check operation to determine whether the clock signal has a duty within a target range.

Another aspect of the present disclosure not covered by the invention provides a method for duty cycle correction, comprising: performing a loop of duty tuning operations to a clock signal by using a binary weighted approximation method; in response to determining that a loop count reaches a threshold value, executing a duty check to the clock signal; and in response to determining that the clock signal has a duty within a target range, passing the duty cycle correction.

In some implementations, the method further comprises: before performing the loop of duty tuning operations, converting the clock signal to a pair of differentiated clock signals.

In some implementations, performing each loop of duty tuning operation comprises: converting the pair of differentiated clock signals to a pair of voltages, respectively; comparing at least one of the pair of voltages with a reference voltage to output at least one comparing voltage; and adjusting at least one of the pair of differentiated clock signals by adjusting at least one of duty of the at least one of pair of differentiated clock signals by the binary weighted approximation method, based on the at least one comparing voltage.

In some implementations, the target range is from about 48% to about 52%.

### BRIEF DESCRIPTION OF THE DRAWINGS

The accompanying drawings, which are incorporated herein and form a part of the specification, illustrate aspects of the present disclosure and, together with the description, further serve to explain the principles of the present disclosure and to enable a person skilled in the pertinent art to make and use the present disclosure.
FIG. 1 illustrates a block diagram of an exemplary system having a memory device, according to some aspects of the present disclosure.
FIG. 2A illustrates a diagram of an exemplary memory card having a memory device, according to some aspects of the present disclosure.
FIG. 2B illustrates a diagram of an exemplary solid-state drive (SSD) having a memory device, according to some aspects of the present disclosure.
FIG. 3 illustrates a block diagram of a duty cycle correction (DCC) circuit 300, according to some aspects of the present disclosure.
FIG. 4 illustrates a flow diagram of a duty cycle correcting process, according to some aspects of the present disclosure.
FIG. 5 illustrates a flow diagram of a duty cycle correcting method, according to some aspects of the present disclosure not covered by the invention.
FIG. 6 is an exemplary diagram showing a duty value change of a clock signal versus a number of loops of duty tuning operations using the duty cycle correcting method of FIG. 5, according to some aspects of the present disclosure.
FIG. 7 illustrates a flow diagram of another duty cycle correcting method, according to some aspects of the present disclosure.
FIG. 8 is an exemplary diagram showing a duty value change of a clock signal versus a number of loops of duty tuning operations using the duty cycle correcting method of FIG. 7, according to some aspects of the present disclosure.

The present disclosure will be described with reference to the accompanying drawings.

### DETAILED DESCRIPTION

In general, terminology may be understood at least in part from usage in context. For example, the term "one or more" as used herein, depending at least in part upon context, may be used to describe any feature, structure, or characteristic in a singular sense or may be used to describe combinations of features, structures, or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

It should be readily understood that the meaning of "on," "above," and "over" in the present disclosure should be interpreted in the broadest manner such that "on" not only means "directly on" something but also includes the meaning of "on" something with an intermediate feature or a layer therebetween, and that "above" or "over" not only means the meaning of "above" or "over" something but can also include the meaning it is "above" or "over" something with no intermediate feature or layer therebetween (i.e., directly on something).

Further, spatially relative terms, such as "beneath," "below," "lower," "above" "upper," and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations), and the spatially relative descriptors used herein may likewise be interpreted accordingly.

Aspects of the disclosure may be implemented in hardware, firmware, software, or any combination thereof. Aspects of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read-only memory (ROM); random access memory (RAM); magnetic disk storage media; optical storage media; flash memory devices; dynamic flash memory (DFM) devices, electrical, optical, acoustical, or other forms of propagated signals (e.g., carrier waves, infrared signals, digital signals, etc.), and others. Further, firmware, software, routines, and/or instructions may be described herein as performing certain actions. However, it should be appreciated that such descriptions are merely for convenience and that such actions in fact, result from computing devices, processors, controllers, or other devices executing the firmware, software, routines, instructions, etc.

One aspect of the present disclosure provides a duty cycle correction circuit configured for correcting a high-speed clock signal. In some implementations, the high-speed clock signal is used for adjusting an operational timing in a memory system, such as timing of a programing operation, a reading operation, or a writing operation of a memory device in the memory system. The disclosed duty cycle correction circuit can be a portion of a control circuit of the memory device in the memory system. In some other implementations, the high-speed clock signal is used for adjusting operational timing in any other suitable semiconductor systems or circuits.

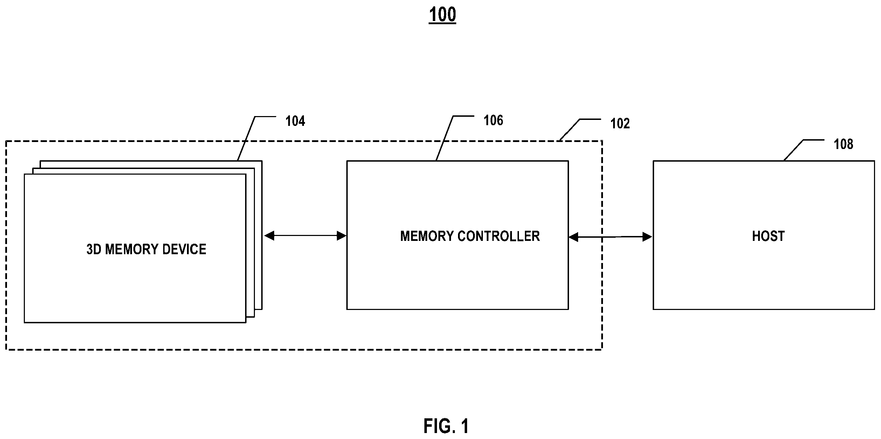

FIG. 1 illustrates a block diagram of a system 100 having a memory device, according to some aspects of the present disclosure. System 100 can be a mobile phone, a desktop computer, a laptop computer, a tablet, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 1, system 100 can include a host 108 and a memory system 102 having one or more memory devices 104 and a memory controller 106. Host 108 can be a processor of an electronic device, such as a central processing unit (CPU), or a system-on-chip (SoC), such as an application processor (AP). Host 108 can be configured to send or receive the data to or from memory devices 104.

Memory device 104 can be any memory devices disclosed herein, such as a 3D memory device. In some implementations, each memory device 104 includes one or more memory cell arrays and one or more peripheral circuits of the memory cell arrays. In some implementations, memory device 104 can be any suitable memory device including, but not limited to read-only memory (ROM) device, random access memory (RAM) device, magnetic disk memory device, optical memory device, flash memory device, dynamic flash memory (DFM) device, etc.

Memory controller 106 is coupled to memory device 104 and host 108 and is configured to control memory device 104, according to some implementations. Memory controller 106 can manage the data stored in memory device 104 and communicate with host 108. In some implementations, memory controller 106 is designed for operating in a low duty-cycle environment like secure digital (SD) cards, compact Flash (CF) cards, universal serial bus (USB) Flash drives, or other media for use in electronic devices, such as personal computers, digital cameras, mobile phones, etc. In some implementations, memory controller 106 is designed for operating in a high duty-cycle environment SSDs or embedded multi-media-cards (eMMCs) used as data storage for mobile devices, such as smartphones, tablets, laptop computers, etc., and enterprise storage arrays. In some implementations, memory controller 106 includes a duty cycle correction circuit configured for correcting a high-speed clock signal.

Memory controller 106 can be configured to control operations of memory device 104, such as read, erase, and program operations. In some implementations, memory controller 106 is configured to control the array of memory cells through the peripheral circuit. Memory controller 106 can also be configured to manage various functions with respect to the data stored or to be stored in memory device 104 including, but not limited to bad-block management, garbage collection, logical-to-physical address conversion, wear leveling, etc. In some implementations, memory controller 106 is further configured to process error correction codes (ECCs) with respect to the data read from or written to memory device 104. Any other suitable functions may be performed by memory controller 106 as well, for example, formatting memory device 104.

Memory controller 106 can communicate with an external device (e.g., host 108) according to a particular communication protocol. For example, memory controller 106 may communicate with the external device through at least one of various interface protocols, such as a USB protocol, an MMC protocol, a peripheral component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc.

Memory controller 106 and one or more memory devices 104 can be integrated into various types of storage devices, for example, be included in the same package, such as a universal Flash storage (UFS) package or an eMMC package. That is, memory system 102 can be implemented and packaged into different types of end electronic products.

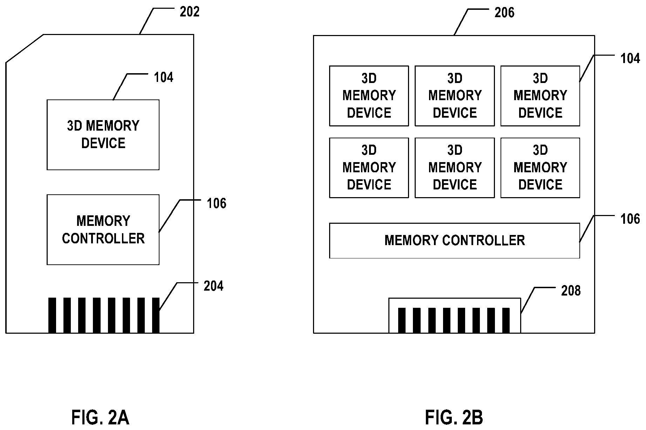

In one example as shown in FIG. 2A, memory controller 106 and a single memory device 104 may be integrated into a memory card 202. Memory card 202 can include a PC card (PCMCIA, personal computer memory card international association), a CF card, a smart media (SM) card, a memory stick, a multimedia card (MMC, RS-MMC, MMCmicro), an SD card (SD, miniSD, microSD, SDHC), a UFS, etc. Memory card 202 can further include a memory card connector 204 coupling memory card 202 with a host (e.g., host 108 in FIG. 1). In another example as shown in FIG. 2B, memory controller 106 and multiple memory devices 104 may be integrated into an SSD 206. SSD 206 can further include an SSD connector 208 coupling SSD 206 with a host (e.g., host 108 in FIG. 1). In some implementations, the storage capacity and/or the operation speed of SSD 206 is greater than those of memory card 202.

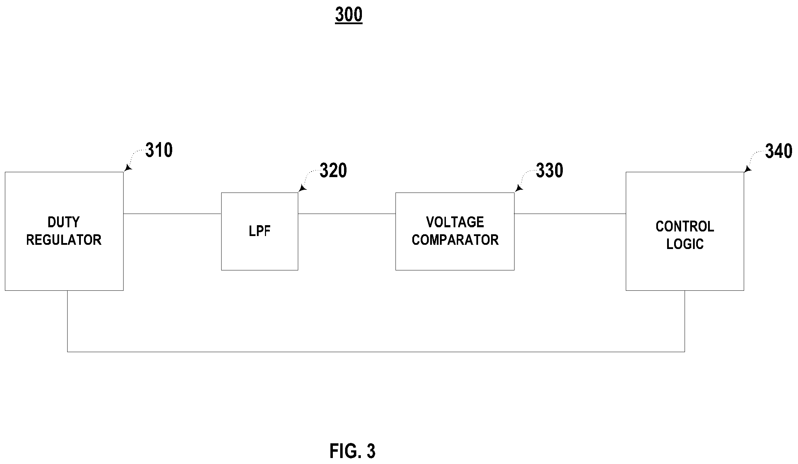

FIG. 3 illustrates a block diagram of a duty cycle correction (DCC) circuit 300, according to some aspects of the present disclosure. DCC circuit 300 can be an analog DCC circuit, a digital DCC circuit, or a digital-analog hybrid DCC circuit. In some implementations, the analog DCC circuit can have a high correction precision, the digital DCC circuit can have a high correction speed, and the digital-analog hybrid DCC circuit can combine a digital DCC sub-circuit and an analog DCC sub-circuit to obtain a tradeoff between the correction speed and the correction precision.

As shown in FIG. 3, DCC circuit 300 can include a duty regulator 310, a low pass filter (LPF) 320, a voltage comparator 330, and a control logic 340. The LPF 320 is configured for receiving an input clock signal, and converting a clock signal to a voltage signal. The voltage comparator 330 is connected to the LPF 320 to receive the voltage signal, and is configured for comparing the voltage signal to a reference voltage to output a comparison signal. The control logic 340 is connected to the voltage comparator 330 to receive the voltage signal, and is configured to generate a control signal according to the comparison signal. The duty regulator 310 is connected to the control logic 340 to receive the control signal, and is configured to adjust the duty cycle of the clock signal based on the control signal.

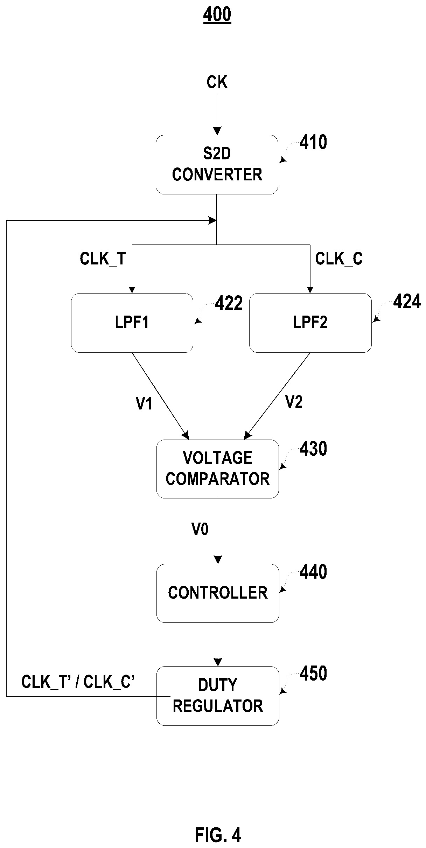

FIG. 4 illustrates a flow diagram of a duty cycle correcting process 400 using DCC circuit 300, according to some aspects of the present disclosure. As shown in FIG. 4, a clock signal CK, such as a high-speed clock signal, can be transmitted to a signal-to-differential (S2D) converter 410. The S2D converter 410configured to convert the clock signal CK to a pair of differentiated clock signals, such as true clock signal CLK_T and complementary clock signal CLK_C.

In some implementations in a memory system, a positive clock edge for a memory device refers to the point where the rising true clock signal CLK_T crosses the falling complementary clock signal CLK_C, while the negative clock edge indicates that the transition of the falling true clock signal CLK_T and the rising of the complementary clock signal CLK_C. Operational commands (e.g., read command, write command, etc.) of the memory device are typically entered on the positive edges of the clock signal, and data is transmitted or received on both the positive and negative clock edges.

As shown in FIG. 4, a pair of low pass filters (LPFs) 422 and 424 can be configured to convert the pair of differentiated clock signals to a pair of voltage signals, respectively. Specifically, true clock signal CLK_T can be converted by the first LPF 422 to a first voltage V1, and complementary clock signal CLK_C can be converted by the second LPF 424 to a second voltage V2. The pair of voltages V1 and V2 can be inputted into a voltage comparator 430 to compare with each other. An output voltage V0 of the voltage comparator 430 can indicate the comparison result.

At least based on the comparison result, a controller 440 can determine a duty cycle correction method. In some implementations, the controller 440 can be configured to can select one cycle correction method of two or more cycle correction methods. For example, controller 440 can select a duty cycle correction method from a linear approximation method or a binary weighted approximation method. It is noted that, the selection of the duty cycle correction method can be determined based at least on the output voltage V0 of the voltage comparator 430, and any other suitable factors. According to the control signal outputted by the controller 440, the duty regulator 450 can perform the selected duty cycle correction method to regulate the pair of differentiated clock signals by adjusting duties of the pair of differentiated clock signals. As such, the adjusted true clock signal CLK_T' and the regulated complementary clock signal CLK_C' can be outputted by the duty regulator 450 for a next loop.

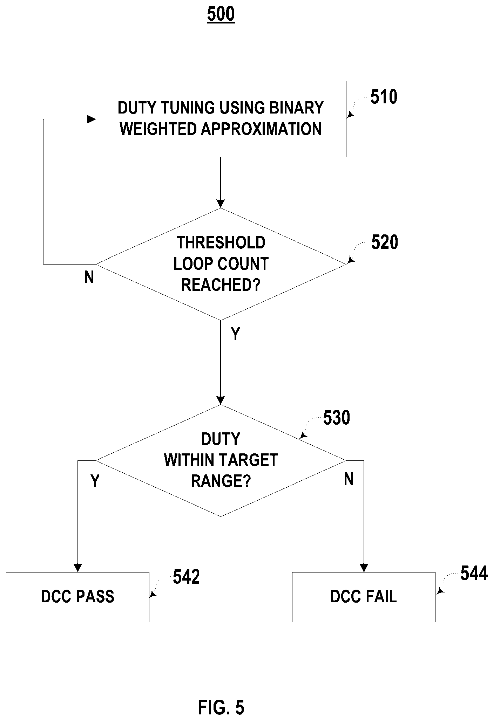

FIG. 5 illustrates a flow diagram of a duty cycle correcting method 500, according to some aspects of the present disclosure not covered by the invention. In some implementations, duty cycle correcting method 500 can be performed by the DCC circuit 300 described above in connection with FIGs. 3 and 4.

As shown in FIG. 5, duty cycle correcting method 500 can start at operation 510, in which a duty tuning operation can be performed to a clock signal by using a binary weighted approximation method. In some implementations, the controller 440 can determine that a binary weighted approximation method is selected to regulate the duty of the true clock signal CLK_T or the complementary clock signal CLK_C. The duty regulator 450 can perform a duty tuning operation by using a binary weighted approximation method to adjust the duty of the true clock signal CLK_T or the duty of the complementary clock signal CLK_C.

At operation 520, duty cycle correcting method 500 can determine whether a loop count reaches a threshold value. In some implementations, after the duty regulator 450 performs a duty tuning operation, the controller 440 can increase a loop count of performed duty tuning operations by one. The controller 440 can further compare the loop count with a threshold value. In some implementations, the threshold loop count value can be predetermined to set a maximum time up-limit of the duty correction process. In response to the loop count is less than the predetermined threshold value ("N" at operation 520), duty cycle correcting method 500 can loop back to operation 510 to perform a next duty tuning operation.

In response to the loop count being equal to or larger than the predetermined threshold value ("Y" at operation 520), duty cycle correcting method 500 can proceed to operation 530 to execute a duty check. The duty check is executed to determine whether the duty of the clock signal is within a target range. In some implementations, a target range of the duty of the clock signal can be predetermined, such as a range between 45% to 55%, a range between 48% to 52%, or a range between 49% to 51%. After a certain number of loops of the duty tuning operations performed at 510, the controller 440 can determine whether the duty of the true clock signal CLK_T or the duty of the complementary clock signal CLK_C is within the predetermined target range. In response to determining that the duty of the clock signal is within the target range ("Y" at operation 530), the controller 440 can determine that the duty cycle correction (DCC) process is successful, and can generate a DCC pass signal at operation 542. In response to determining that the duty of the clock signal is not within the target range ("N" at operation 530), the controller 440 can determine that the duty cycle correction (DCC) process is unsuccessful, and can generate a DCC fail signal at operation 544.

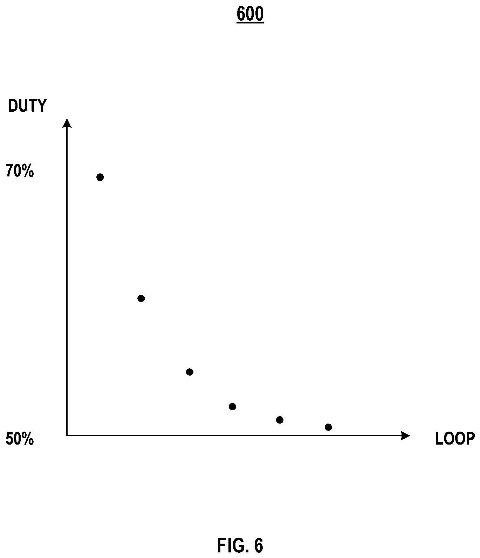

FIG. 6 is an exemplary diagram showing a duty value change of a clock signal versus a number of loops of duty tuning operations using a binary weighted approximation method. Compared to the linear approximation method, in which each loop has a fixed tuning step, the binary weighted approximation method can have a variable tuning step depending on the current value of the clock signal duty. Specifically, the binary weighted approximation method can adjust the duty by a large tuning step in a duty tuning loop when the clock signal duty is far from the target range, and can adjust the duty by a small tuning step in a duty tuning loop when the clock signal duty is close the target range.

For example, as shown in FIG. 6, in the first duty tuning loop, the clock signal having a duty cycle of around 70% can be tuned to less than 60% by decreasing a large tuning step of more than 10%. In a fifth duty tuning loop, the clock signal having a duty cycle of around 52% can be tuned to about 51% by decreasing a small tuning step of about 1%. It is note that, when using the linear approximation method having a large tuning step, the final duty value may not be precisely adjusted into a small target range. When using the linear approximation method having a small tuning step, the duty cycle correction process may spend a large amount of time due to the large number of loops. By using the binary weighted approximation method, a high correction speed and a high correction precision can both be achieved. For example, as shown in FIG. 6, a clock signal having a duty cycle of around 70% can be tuned within a small target range close to 50% in merely 5 loops of duty tuning operations by using the binary weighted approximation method.

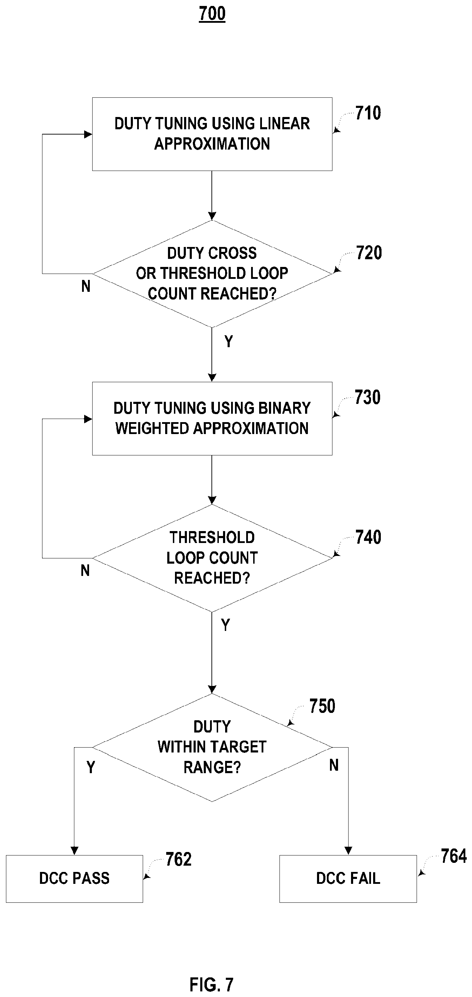

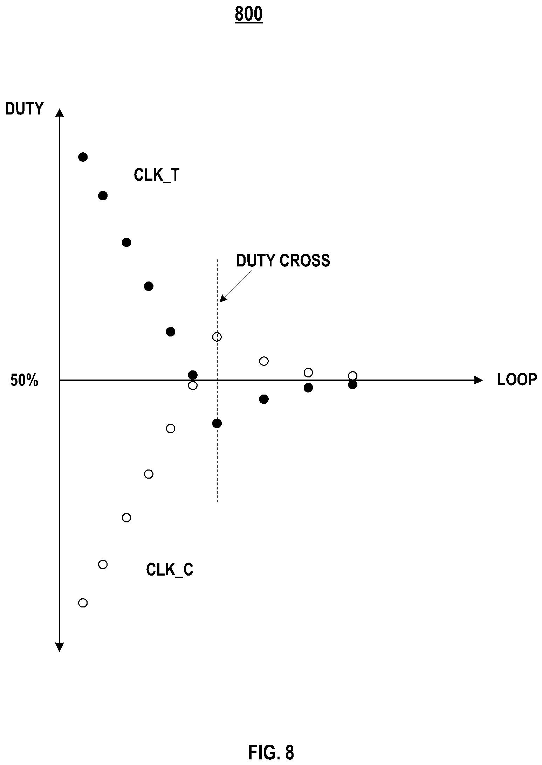

FIG. 7 illustrates a flow diagram of a duty cycle correcting method 700 using both linear approximation and binary weighted approximation, according to some aspects of the present disclosure. In some implementations, duty cycle correcting method 700 can be performed by the DCC circuit 300 described above in connection with FIGs. 3 and 4. FIG. 8 is an exemplary diagram showing a duty value change of a clock signal versus a number of loops of duty tuning operations using both linear approximation and binary weighted approximation. In some implementations, duty cycle correcting method 700 can first perform a first subset of loops of duty tuning operations using the linear approximation, and then perform a second subset of loops of duty tuning operations using the binary weighted approximation.

As shown in FIG. 7, duty cycle correcting method 700 can start at operation 710, in which a duty tuning operation can be performed to a clock signal by using a linear approximation method. In some implementations, the controller 440 can determine that a linear approximation method is firstly selected to regulate the duty of the true clock signal CLK_T and the complementary clock signal CLK_C. The duty regulator 450 can perform a duty tuning operation by using the linear approximation method to adjust the duty of the true clock signal CLK_T and the duty of the complementary clock signal CLK_C.

At operation 720, duty cycle correcting method 700 can determine whether a loop count reaches a threshold value and whether a duty cross occurs. In some implementations, after the duty regulator 450 performs a duty tuning operation, the controller 440 can increase a loop count of performed duty tuning operations by one. The controller 440 can further compare the loop count with a first threshold value. In some implementations, the threshold loop count value can be predetermined to set an up-limit of the duty tuning loops using the linear approximation method. Further, the voltage comparator 430 can determine if a duty cross occurs by comparing the voltages values (e.g., voltages V1 and V2 as shown in FIG. 4) of the tuned true clock signal CLK_T and the tuned complementary clock signal CLK_C.

In response to the loop count being less than the first threshold value and a duty cross does not occur ("N" at operation 720), duty cycle correcting method 700 can loop back to operation 710 to perform a next duty tuning operation using the linear approximation method. As shown in FIG. 8, the first five loops of cycle tuning operations use the linear approximation method having a fixed tuning step.

In response to the loop count reaching the first threshold value or a duty cross is detected ("Y" at operation 720), duty cycle correcting method 700 can proceed to operation 730, in which a duty tuning operation can be performed by using the binary weighted approximation method. In some implementations, the controller 440 can determine to switch from the linear approximation method to the binary weighted approximation method based on the determination result at operation 720. For example, as shown in FIG. 8, after the sixth loop of cycle tuning operations using the linear approximation method, a comparison result indicating that the duty of complementary clock signal CLK_C becomes larger than the duty of true clock signal CLK_T, i.e., a duty cross is detected. The controller 440 can accordingly change to the binary weighted approximation method in the subsequent loops of duty tuning operations.

At operation 740, duty cycle correcting method 700 can determine whether a loop count reaches a second threshold value. Similarly, after the duty regulator 450 performs each duty tuning operation, the controller 440 can increase the loop count, and compare the loop count with a second threshold value. In some implementations, the second threshold loop count value can be predetermined to set a maximum time up-limit of the duty correction process. In response to the loop count being less than the second threshold value ("N" at operation 740), duty cycle correcting method 700 can loop back to operation 730 to perform a next duty tuning operation using the binary weighted approximation method.

In response to the loop count being equal to or larger than the second threshold value ("Y" at operation 740), duty cycle correcting method 700 can proceed to operation 750 to execute a duty check. The duty check is executed to determine whether the duty of the clock signal is within a target range. In some implementations, the target range of the duty of the clock signal can be predetermined, such as a range between 45% to 55%, a range between 48% to 52%, or a range between 49% to 51%. The controller 440 can determine whether the duty of the true clock signal CLK_T and the duty of the complementary clock signal CLK_C are within the predetermined target range. In response to determining that the duties of the clock signals are within the target range ("Y" at operation 750), the controller 440 can determine that the duty cycle correction (DCC) process is successful, and can generate a DCC pass signal at operation 762. In response to determining that the duties of the clock signals are not within the target range ("N" at operation 750), the controller 440 can determine that the duty cycle correction (DCC) process is unsuccessful, and can generate a DCC fail signal at operation 764.

As shown in FIG. 8, by using the linear approximation method having a fixed tuning step in a first subset of a first subset of loops of duty tuning operations before the duty cross, and then using the binary weighted approximation having a variable tuning step in a second subset of loops of duty tuning operations after the duty cross, a high correction speed and a high correction precision can be both achieved.

The foregoing description of the specific implementations can be readily modified and/or adapted for various applications. Therefore, such adaptations and modifications are intended to be within the meaning and range of equivalents of the disclosed implementations, based on the teaching and guidance presented herein.

The breadth and scope of the present disclosure should not be limited by any of the above-described exemplary implementations, but should be defined only in accordance with the following claims.

Although specific configurations and arrangements are discussed, it should be understood that this is done for illustrative purposes only. As such, other configurations and arrangements can be used without departing from the scope of the present disclosure. Also, the subject matter as described in the present disclosure can also be used in a variety of other applications. Functional and structural features as described in the present disclosures can be modified, in ways that are consistent with the scope of the present invention.

## Claims

1. A method (500, 700) for duty cycle correction, comprising:
performing a first loop of duty tuning operations to a clock signal by using a first method; in response to determining that a first loop count of the first loop, wherein the first loop count is the number of iterations of the first loop of duty tuning operations, reaches a first threshold
value, or determining that a duty cross occurs, performing a second loop of duty tuning operations to the clock signal by using a second method different from the first method;
in response to determining that a second loop count of the second loop, wherein the second loop count is the number of iterations of the second loop of duty tuning operations, reaches a second threshold value, executing a duty check to the clock signal; and
in response to determining that the clock signal has a duty cycle within a target range, passing the duty cycle correction,
wherein the first method is a linear approximation method, and the second method is a binary weighted approximation method; and
wherein the method (500, 700) further comprises:
before performing the first loop of duty tuning operations, converting the clock signal to a pair of differentiated clock signals, preferably further comprising:
converting the pair of differentiated clock signals to a pair of voltages, respectively; and comparing the pair of voltages to output a comparison signal to indicate whether the duty cross occurs.

2. The method (500, 700) of claim 1, wherein the target range of the duty cycle of the clock signal is from about 48% to about 52%.

3. A circuit (300) for duty cycle correction, comprising:
at least one filter configured to convert a clock signal to a voltage;
a voltage comparator (330, 430) configured to compare the voltage with a reference voltage to output a comparison signal;
a controller (106, 440) configured to select, based on the comparing voltage, a duty cycle correction method from a first method and a second method different from the first method; and
a duty regulator (310, 450) configured to perform a duty tuning operation to adjust a duty of the clock signal using the selected duty cycle correction method, **characterized in that**: the first method is a linear approximation method; and the second method is a binary weighted approximation method.

4. The circuit (300) of claim 3, further comprising:
a single-to-differential converter configured to convert the clock signal to a pair of differentiated clock signals.

5. The circuit (300) of claim 4, wherein:
the at least one filter (320) comprises a pair of low pass filters (320) configured to convert the pair of differentiated clock signals to a pair of voltages, respectively; and
the voltage comparator (330, 430) is configured to compare the pair of voltages to generate the comparison signal indicating whether a duty cross occurs.

6. The circuit (300) of claim 5, wherein the controller (106, 440) is further configured to:
select the linear approximation method in response to the comparison signal indicating that the duty cross does not occur; and
select the binary weighted approximation method in response to the comparison signal indicating that the duty cross occurs.

7. The circuit (300) of claim 6, wherein the controller (106, 440) is further configured to:
count a first loop count of a first subset of loops of duty tuning operations, wherein the first loop count is the number of iterations of the first subset of loops of duty tuning operations, using the linear approximation method; and
in response to determining that the first loop count reaches a first threshold value, select the binary weighted approximation method.

8. The circuit (300) of claim 7, wherein the controller (106, 440) is further configured to:
a) in response to determining that the first loop count does not reach the first threshold value and the comparison signal indicating that the duty cross does not occur, select the linear approximation method;
or
b) in response to determining that the first loop count does not reach the first threshold value and the comparison signal indicating that the duty cross does not occur, select the linear approximation method; and count a second loop count of a second subset of loops of duty tuning operations, wherein the second loop count is the number of iterations of the second subset of loops of duty tuning operations, using the binary weighted approximation method; and in response to determining that the second loop count reaches a second threshold value, perform a duty check operation to determine whether the clock signal has a duty within a target range and wherein preferably
the controller (106, 440) is further configured to:
in response to determining that the duty of the clock signal is within the target range, generate a pass signal indicating that the duty cycle correction is successful; and in response to determining that the duty of the clock signal is without the target range, generate a fail signal indicating that the duty cycle correction is unsuccessful.

9. A memory system (102), comprising:
a memory device (104); and
a peripheral circuit configured to control the memory device (104), the peripheral circuit comprising a duty cycle correction circuit according to claim 3.

10. The memory system (102) of claim 9, wherein the duty cycle correction circuit further comprises:
a single-to-differential converter configured to convert the clock signal to a pair of differentiated clock signals.

11. The memory system (102) of claim 10, wherein:
the at least one filter (320) comprises a pair of low pass filters (320) configured to convert the pair of differentiated clock signals to a pair of voltages, respectively; and
the voltage comparator (330, 430) is configured to compare the pair of voltages to generate the comparison signal indicating whether a duty cross occurs.

12. The memory system (102) of claim 11, wherein the controller (106, 440) is further configured to: count a first loop count of a first subset of loops of duty tuning operations, wherein the first loop count is the number of iterations of the first subset of loops of duty tuning operations, using the linear
approximation method (500, 700);
in response to determining that the first loop count reaches a first threshold value or the comparison signal indicating that the duty cross occurs, select the binary weighted approximation method; and
in response to determining that the first loop count does not reaches the first threshold value and the comparison signal indicating that the duty cross does not occur, select the linear approximation method, preferably
wherein the controller (106, 440) is further configured to:
count a second loop count of a second subset of loops of duty tuning operations, wherein the second loop count is the number of iterations of the second subset of loops of duty tuning operations, using the binary weighted approximation method; and in response to determining that the second loop count reaches a second threshold value, perform a duty check operation to determine whether the clock signal has a duty within a target range.

## Patentansprüche

1. Verfahren (500, 700) zur Tastverhältnis-Korrektur, umfassend:
Ausführen einer ersten Schleife von Vorgängen zur Abstimmung des Tastverhältnisses eines Taktsignals durch Anwenden einer ersten Methode;
Ausführen einer zweiten Schleife von Vorgängen zur Abstimmung des Tastverhältnisses des Taktsignals durch Anwenden einer sich von der ersten Methode unterscheidenden zweiten Methode in Reaktion auf die Feststellung, dass ein erster Schleifendurchlauf-Zählwert der ersten Schleife, der die Anzahl von Wiederholungen der ersten Schleife von Vorgängen zur Abstimmung des Tastverhältnisses ist, einen ersten Schwellenwert erreicht, oder die Feststellung, dass ein Duty Cross vorliegt;
Ausführen einer Prüfung des Tastverhältnisses des Taktsignals in Reaktion auf die Feststellung, dass ein zweiter Schleifendurchlauf-Zählwert der zweiten Schleife, der die Anzahl von Wiederholungen der zweiten Schleife von Vorgängen zur Abstimmung des Tastverhältnisses ist, einen zweiten Schwellenwert erreicht; und
Freigabe der Tastverhältnis-Korrektur in Reaktion auf die Feststellung, dass das Taktsignal ein Tastverhältnis innerhalb eines Sollbereichs aufweist,
wobei die erste Methode eine lineare Approximation und die zweite Methode eine binäre gewichtete Approximation ist; und wobei das Verfahren (500, 700) ferner umfasst:
Umwandeln des Taktsignals in ein Paar von differentiellen Taktsignalen vor dem Ausführen der ersten Schleife von Vorgängen zur Abstimmung des Tastverhältnisses, vorzugsweise ferner umfassend:
Umwandeln des Paares von differentiellen Taktsignalen jeweils in ein Spannungspaar und Vergleichen des Spannungspaares, um ein Vergleichssignal auszugeben, um anzuzeigen, ob ein Duty Cross vorliegt.

2. Verfahren (500, 700) nach Anspruch 1, wobei der Sollbereich des Tastverhältnisses des Taktsignals zwischen etwa 48% und etwa 52% liegt.

3. Schaltkreis (300) zur Tastverhältnis-Korrektur, umfassend:
mindestens ein Filter, das dazu eingerichtet ist, ein Taktsignal in eine Spannung umzuwandeln;
einen Spannungskomparator (330, 430), der dazu eingerichtet ist, die Spannung mit einer Referenzspannung zu vergleichen, um ein Vergleichssignal auszugeben;
eine Steuerung (106, 440), die dazu eingerichtet ist, basierend auf der Vergleichsspannung eine Tastverhältnis-Korrekturmethode aus einer ersten Methode und einer sich von der ersten Methode unterscheidenden zweiten Methode auszuwählen; und
einen Tastverhältnis-Regler (310, 450), der dazu eingerichtet ist, einen Tastverhältnis-Abstimmvorgang durchzuführen zur Einstellung eines Tastverhältnisses des Taktsignals mittels der gewählten Tastverhältnis-Korrekturmethode,
**dadurch gekennzeichnet, dass**
die erste Methode eine lineare Approximationsmethode ist; und die zweite Methode eine binär gewichtete
Approximationsmethode ist.

4. Schaltkreis (300) nach Anspruch 3, ferner umfassend: einen Single-to-Differential-Konverter, der dazu eingerichtet ist, das Taktsignal in ein Paar von differentiellen Signalen umzuwandeln.

5. Schaltkreis (300) nach Anspruch 4, wobei:
das mindestens eine Filter (320) ein Paar von Tiefpassfiltern (320) umfasst, die dazu eingerichtet sind, das Paar von differentiellen Taktsignalen jeweils in ein Spannungspaar umzuwandeln; und
der Spannungskomparator (330, 430) dazu eingerichtet ist, das Spannungspaar zu vergleichen, um das Vergleichssignal zu erzeugen, das anzeigt, ob ein Duty Cross vorliegt.

6. Schaltkreis (300) nach Anspruch 5, wobei die Steuerung (106, 440) ferner dazu eingerichtet ist:
in Reaktion darauf, dass das Vergleichssignal anzeigt, dass das Duty Cross nicht vorliegt, die lineare Approximationsmethode zu wählen; und
in Reaktion darauf, dass das Vergleichssignal anzeigt, dass das Duty Cross vorliegt, die binär gewichtete Approximationsmethode zu wählen.

7. Schaltkreis (300) nach Anspruch 6, wobei die Steuerung (106, 440) ferner dazu eingerichtet ist:
unter Anwendung der linearen Approximationsmethode einen ersten Schleifendurchlauf-Zählwert einer ersten Teilmenge von Schleifen von Vorgängen zur Abstimmung des Tastverhältnisses zu ermitteln, wobei der erste Schleifendurchlauf-Zählwert die Anzahl von Wiederholungen der ersten Teilmenge von Schleifen von Vorgängen zur Abstimmung des Tastverhältnisses ist; und
in Reaktion auf die Feststellung, dass der erste Schleifendurchlauf-Zählwert einen ersten Schwellenwert erreicht, die binäre gewichtete Approximationsmethode zu wählen.

8. Schaltkreis (300) nach Anspruch 7, wobei die Steuerung (106, 440) ferner dazu eingerichtet ist:
a) in Reaktion auf die Feststellung, dass der erste Schleifendurchlauf-Zählwert den ersten Schwellenwert nicht erreicht und das Vergleichssignal anzeigt, dass das Duty Cross nicht vorliegt, die lineare Approximationsmethode zu wählen;
ODER
b) in Reaktion auf die Feststellung, dass der erste Schleifendurchlauf-Zählwert den ersten Schwellenwert nicht erreicht und das Vergleichssignal anzeigt, dass das Duty Cross nicht vorliegt, die lineare Approximationsmethode zu wählen; und unter Anwendung der binär gewichteten Approximationsmethode einen zweiten Schleifendurchlauf-Zählwert einer zweiten Teilmenge von Schleifen von Vorgängen zur Abstimmung des Tastverhältnisses zu ermitteln, wobei der zweite Schleifendurchlauf-Zählwert die Anzahl von Wiederholungen der zweiten Teilmenge von Schleifen von Vorgängen zur Abstimmung des Tastverhältnisses ist; und in Reaktion auf die Feststellung, dass der zweite Schleifendurchlauf-Zählwert einen zweiten Schwellenwert erreicht, eine Tastverhältnisprüfung durchzuführen, um festzustellen, ob das Taktsignal ein Tastverhältnis innerhalb eines Sollwerts aufweist, und wobei vorzugsweise die Steuerung (106, 440) ferner dazu eingerichtet ist:
in Reaktion auf die Feststellung, dass das Tastverhältnis des Taktsignals innerhalb des Sollwerts liegt, ein Gut-Signal zu erzeugen, das auf die erfolgreiche Korrektur des Tastverhältnisses hinweist; und in Reaktion auf die Feststellung, dass das Tastverhältnis des Taktsignals außerhalb des Sollwerts liegt, ein Schlecht-Signal zu erzeugen, das darauf hinweist, dass die Korrektur des Tastverhältnisses nicht erfolgreich war.

9. Speichersystem (102), umfassend:
eine Speichervorrichtung (104); und
eine Peripherieschaltung, die konfiguriert ist zum Steuern der Speichervorrichtung (104), wobei die Peripherieschaltung einen Tastverhältnis-Korrekturschaltkreis gemäß Anspruch 3 umfasst.

10. Speichersystem (102) nach Anspruch 9, wobei der Tastverhältnis-Korrekturschaltkreis ferner umfasst:
einen Single-to-Differential-Konverter, der dazu eingerichtet ist, das Taktsignal in ein Paar von differentiellen Taktsignalen umzuwandeln.

11. Speichersystem (102) nach Anspruch 10, wobei:
das mindestens eine Filter (320) ein Paar von Tiefpassfiltern (320) umfasst, die konfiguriert sind zum Umwandeln des Paares von differentiellen Taktsignalen jeweils in ein Spannungspaar; und
der Spannungskomparator (330, 430) dazu eingerichtet ist, das Spannungspaar zu vergleichen, um das Vergleichssignal zu erzeugen, das anzeigt, ob ein Duty Cross vorliegt.

12. Speichersystem (102) nach Anspruch 11, wobei die Steuerung (106, 440) ferner dazu eingerichtet ist:
unter Anwendung der linearen Approximationsmethode (500, 700) einen ersten Schleifendurchlauf-Zählwert einer ersten Teilmenge von Schleifen von Vorgängen zur Abstimmung des Tastverhältnisses zu ermitteln, wobei der erste Schleifendurchlauf-Zählwert die Anzahl von Wiederholungen der ersten Teilmenge von Schleifen von Vorgängen zur Abstimmung des Tastverhältnisses;
in Reaktion auf die Feststellung, dass der erste Schleifendurchlauf-Zählwert einen ersten Schwellenwert erreicht oder das Vergleichssignal anzeigt, dass das Duty Cross vorliegt, die binär gewichtete Approximationsmethode zu wählen; und
in Reaktion auf die Feststellung, dass der erste Schleifendurchlauf-Zählwert den ersten Schwellenwert nicht erreicht und das Vergleichssignal anzeigt, dass das Duty Cross nicht vorliegt, die lineare Approximationsmethode zu wählen,
wobei vorzugsweise die Steuerung (106, 440) ferner dazu eingerichtet ist:
unter Anwendung der binär gewichteten Approximationsmethode einen zweiten Schleifendurchlauf-Zählwert einer zweiten Teilmenge von Schleifen von Vorgängen zur Abstimmung des Tastverhältnisses zu ermitteln, wobei der zweite Schleifendurchlauf-Zählwert die Anzahl von Wiederholungen der zweiten Teilmenge von Schleifen von Tastverhältnis-Abstimmvorgängen ist; und in Reaktion auf die Feststellung, dass der zweite Schleifendurchlauf-Zählwert einen zweiten Schwellenwert erreicht, eine Prüfung des Tastverhältnisses durchzuführen, um festzustellen, ob das Taktsignal ein Tastverhältnis innerhalb eines Sollbereichs aufweist.

## Revendications

1. Procédé (500, 700) de correction du rapport cyclique, comprenant:
l'exécution d'une première boucle d'opérations de réglage du rapport cyclique sur un signal d'horloge à l'aide d'un premier méthode;
en réponse à la détermination qu'un premier compteur de la première boucle, ce premier compteur étant le nombre d'itérations de la première boucle d'opérations de réglage du rapport cyclique, atteint une première valeur seuil, ou à la détermination qu'un croisement du rapport cyclique se produit, l'exécution d'une deuxième boucle d'opérations de réglage du rapport cyclique sur le signal d'horloge à l'aide d'un deuxième procédé différent du premier procédé;
en réponse à la détermination qu'un deuxième compteur de la deuxième boucle, ce deuxième compteur étant le nombre d'itérations de la deuxième boucle d'opérations de réglage du rapport cyclique, atteint une deuxième valeur seuil, l'exécution d'une vérification du rapport cyclique du signal d'horloge; et
en réponse à la détermination que le signal d'horloge présente un rapport cyclique compris dans une plage cible, valider la correction du rapport cyclique,
dans lequel la première méthode est une méthode d'approximation linéaire, et la deuxième méthode est une méthode d'approximation à pondération binaire; et
dans lequel le procédé (500, 700) comprend en outre:
avant d'exécuter la première boucle d'opérations de réglage du rapport cyclique, convertir le signal d'horloge en une paire de signaux d'horloge différenciés, comprenant de préférence en outre:
la conversion de la paire de signaux d'horloge différenciés en une paire de tensions, respectivement; et la comparaison de la paire de tensions pour émettre un signal de comparaison indiquant si le croisement du rapport cyclique se produit.

2. Procédé (500, 700) selon la revendication 1, dans lequel la plage cible du rapport cyclique du signal d'horloge est comprise entre environ 48 % et environ 52 %.

3. Circuit (300) de correction du rapport cyclique, comprenant:
au moins un filtre configuré pour convertir un signal d'horloge en une tension;
un comparateur de tension (330, 430) configuré pour comparer la tension à une tension de référence afin de générer un signal de comparaison;
un dispositif de commande (106, 440) configuré pour sélectionner, en fonction de la tension de comparaison, un procédé de correction du rapport cyclique parmi un premier procédé et un second procédé différent du premier; et
un régulateur de rapport cyclique (310, 450) configuré pour effectuer une opération de réglage du rapport cyclique afin d'ajuster le rapport cyclique du signal d'horloge à l'aide du procédé de correction de rapport cyclique sélectionné, **caractérisé en ce que**:
la première méthode est une méthode d'approximation linéaire; et la deuxième méthode est une méthode d'approximation à pondération binaire.

4. Circuit (300) selon la revendication 3, comprenant en outre:
un convertisseur simple-différentiel configuré pour convertir le signal d'horloge en une paire de signaux d'horloge différenciés.

5. Circuit (300) selon la revendication 4, dans lequel: ledit au moins un filtre (320) comprend une paire de filtres passe-bas (320) configurés pour convertir respectivement la paire de signaux d'horloge différenciés en une paire de tensions; et le comparateur de tension (330, 430) est configuré pour comparer la paire de tensions afin de générer le signal de comparaison indiquant si un croisement du rapport cyclique se produit.

6. Circuit (300) selon la revendication 5, dans lequel le dispositif de commande (106, 440) est en outre configuré pour:
sélectionner la méthode d'approximation linéaire en réponse au signal de comparaison indiquant qu'aucun croisement de rapport cyclique ne se produit; et
sélectionner la méthode d'approximation á pondération binaire en réponse au signal de comparaison indiquant que le croisement de rapport cyclique se produit.

7. Circuit (300) selon la revendication 6, dans lequel le dispositif de commande (106, 440) est en outre configuré pour:
compter un premier nombre de boucles d'un premier sous-ensemble de boucles d'opérations de réglage du rapport cyclique, le premier nombre de boucles correspondant au nombre d'itérations du premier sous-ensemble de boucles d'opérations de réglage du rapport cyclique, en utilisant la méthode d'approximation linéaire; et
en réponse à la détermination que le premier nombre de boucles atteint une première valeur seuil, sélectionner la méthode d'approximation à pondération binaire.

8. Circuit (300) selon la revendication 7, dans lequel le dispositif de commande (106, 440) est en outre configuré pour:
a) en réponse à la détermination que le premier nombre de boucles n'atteint pas la première valeur seuil et que le signal de comparaison indique que le croisement du rapport cyclique ne se produit pas, sélectionner la méthode d'approximation linéaire;
ou
b) en réponse à la détermination que le premier nombre de boucles n'atteint pas la première valeur seuil et que le signal de comparaison indique que le croisement du rapport cyclique ne se produit pas, sélectionner la méthode d'approximation linéaire; et compter un deuxième nombre de boucles d'un deuxième sous-ensemble de boucles d'opérations de réglage du rapport cyclique, le deuxième nombre de boucles correspondant au nombre d'itérations du deuxième sous-ensemble de boucles d'opérations de réglage du rapport cyclique, en utilisant la méthode d'approximation à pondération binaire; et, en réponse à la détermination que le deuxième nombre de boucles atteint une deuxième valeur seuil, effectuer une opération de vérification du rapport cyclique afin de déterminer si le signal d'horloge présente un rapport cyclique compris dans une plage cible, et dans lequel, de préférence,
le dispositif de commande (106, 440) est en outre configuré pour:
en réponse à la détermination que le rapport cyclique du signal d'horloge se situe dans la plage cible, générer un signal de réussite indiquant que la correction du rapport cyclique est une réussite; et en réponse à la détermination que le rapport cyclique du signal d'horloge se situe en dehors de la plage cible, générer un signal d'échec indiquant que la correction du rapport cyclique a échoué.

9. Système de mémoire (102), comprenant:
un dispositif de mémoire (104); et
un circuit périphérique configuré pour commander le dispositif de mémoire (104), le circuit périphérique comprenant un circuit de correction du rapport cyclique selon la revendication 3.

10. Système de mémoire (102) selon la revendication 9, dans lequel le circuit de correction du rapport cyclique comprend en outre:
un convertisseur simple-différentiel configuré pour convertir le signal d'horloge en une paire de signaux d'horloge différenciés.

11. Système de mémoire (102) selon la revendication 10, dans lequel:
ledit au moins un filtre (320) comprend une paire de filtres passe-bas (320) configurés pour convertir la paire de signaux d'horloge différenciés en une paire de tensions, respectivement; et le comparateur de tensions (330, 430) est configuré pour comparer la paire de tensions afin de générer le signal de comparaison indiquant si un croisement de rapport cyclique se produit.

12. Système de mémoire (102) selon la revendication 11, dans lequel le contrôleur (106, 440) est en outre configuré pour: compter un premier nombre de boucles d'un premier sous-ensemble de boucles d'opérations de réglage du rapport cyclique, le premier nombre de boucles correspondant au nombre d'itérations du premier sous-ensemble de boucles d'opérations de réglage du rapport cyclique, à l'aide de la méthode d'approximation linéaire (500, 700);
en réponse à la détermination que le premier nombre de boucles atteint une première valeur seuil ou que le signal de comparaison indique qu'un croisement du rapport cyclique se produit, sélectionner la méthode d'approximation à pondération binaire; et
en réponse à la détermination que le premier nombre de boucles n'atteint pas la première valeur seuil et que le signal de comparaison indique qu'un croisement du rapport cyclique ne se produit pas, sélectionner la méthode d'approximation linéaire, de préférence
dans lequel le dispositif de commande (106, 440) est en outre configuré pour:
compter un deuxième nombre de boucles d'un deuxième sous-ensemble de boucles d'opérations de réglage du rapport cyclique, le deuxième nombre de boucles étant le nombre d'itérations du deuxième sous-ensemble de boucles d'opérations de réglage du rapport cyclique, en utilisant la méthode d'approximation à pondération binaire; et en réponse à la détermination que le deuxième nombre de boucles atteint une deuxième valeur seuil, effectuer une opération de vérification du rapport cyclique afin de déterminer si le signal d'horloge présente un rapport cyclique compris dans une plage cible.
